# EUROPEAN PATENT APPLICATION

(11) **EP 1 271 245 A2**
(43) Date of publication of application: **02.01.2003**
(21) Application number: 02013101.7
(22) Date of filing: 13.06.2002
(51) Int. Cl.: G03F 7/16

(54) **Applying apparatus and method of controlling film thickness for enabling uniform thickness**

(30) Priority: 14.06.2001 JP 2001180003
(71) Applicant: NEC CORPORATION, Tokyo (JP)
(72) Inventor: Shimane, Takashi, Minato-ku, Tokyo (JP)
(74) Representative: Glawe, Delfs, Moll & Partner

(57) **Abstract**

An applying apparatus includes an applying unit for applying a photoresist to a semiconductor wafer on the basis of an applying condition, a thickness measuring unit for measuring the film thickness of the photoresist applied, and a control unit for controlling the applying unit. On the basis of information on the applying condition for a predetermined number of samples and information on the film thickness on the predetermined number of samples, the control unit plots an approximate curve that indicates the relation between the film thickness and the applying condition of the predetermined number of samples. When the applying apparatus starts its actual operation, the control unit calculates a correction value of the applying condition from a thickness target value on the basis of the plotted approximate curve, and generates a control signal for controlling the applying condition on the basis of the calculated correction value.

## Description

### BACKGROUND OF THE INVENTION

### Field of the Invention

The present invention relates to an applying apparatus and a method of controlling a film thickness for applying a uniform photoresist to a semiconductor wafer.

### Description of the Related Art

In a lithography process of semiconductor device manufacture, a photoresist is applied to a semiconductor wafer. Various improvements have been so far proposed to ensure a uniform film thickness of the photoresist. It is requested that nonuniformity of film thickness should be restricted to about several tens of micrometers or less.

To ensure the uniform film thickness of the photoresist, the following applying apparatus has been proposed. The apparatus includes an applying unit and a thickness control unit. The applying unit applies the photoresist to the semiconductor wafer by a spin coat method. The thickness control unit controls a spin motor that rotates the semiconductor wafer and includes a thickness measuring device and a feedback control section. The thickness measuring device measures the film thickness of the photoresist applied to the semiconductor wafer (sample), and outputs a signal indicating the measured film thickness. The feedback control section receives the output signal from the thickness measuring device and controls the rotation speed of the spin motor, so that the difference between the measured film thickness and a preset reference value will approach 0. Such an apparatus is disclosed in Japanese Patent Application Laid-open No. 63-198329.

However, in a photoresist applying process, it is required that the film thickness should be managed taking various factors, that is, applying conditions into account. The applying conditions required in the thickness management includes such as the rotation speed of the semiconductor wafer, rotating time of the semiconductor wafer, chemical liquid to be applied, that is, the kind of the photoresist, viscosity of the chemical liquid, the amount of the dropped chemical liquid, the temperature of the chemical liquid, and the ambient humidity. When starting the photoresist applying process, it is necessary to have a check so as to find out the optimum conditions for those applying conditions. Such an applying apparatus requires a relatively long time for the checking, which causes a loss in operation of the applying apparatus.

### SUMMARY OF THE INVENTION

It is therefore an object of the invention to provide an applying apparatus and a method of controlling a film thickness that minimize the loss in operation.

An applying apparatus according to the present invention includes an applying unit for applying a photoresist to a semiconductor wafer by a spin coat method on the basis of at least one applying condition, a thickness measuring unit for measuring the film thickness of the photoresist applied to the semiconductor wafer by the applying unit, and a control unit for controlling the applying unit.

In a first aspect of the present invention, on the basis of information on the at least one applying condition for a predetermined number of samples sent from the applying unit and information on the film thickness on the predetermined number of samples sent from the thickness measuring unit, the control unit plots an approximate curve or a regression curve that indicates the relation between the film thickness and the at least one applying condition of the predetermined number of samples. When the applying apparatus starts its actual operation, the control unit further calculates a correction value of the at least one applying condition from a thickness target value preset in the applying unit on the basis of the approximate curve or the regression curve that are plotted in relation to the predetermined number of samples, and the control unit generates a control signal for controlling the at least one applying condition on the basis of the calculated correction value. The applying unit is controlled by the control signal.

Concretely, in the above first aspect of the present invention, the applying unit sends a predetermined number of semiconductor wafers on which photoresist films are formed by changing a set value of the at least one applying condition as the predetermined number of samples to the thickness measuring unit, and sends information on the at least one applying condition to the control unit. The thickness measuring unit measures the thickness of the photoresist films for each of the predetermined number of samples and sends information on the measured predetermined number of film thicknesses to the control unit. The control unit includes a curve plotter, a correction value calculator, and a control section. The curve plotter plots the approximate curve or the regression curve that indicates the relation between the set value of the at least one applying condition and the film thickness on the sample corresponding to each set value by using the information on at least one applying condition and the information on the predetermined number of film thicknesses. The correction value calculator calculates a correction value of the at least one applying condition from the thickness target value on the basis of the approximate curve or the regression curve. The control section generates the control signal for controlling the at least one applying condition on the basis of the calculated correction value.

In a second aspect of the present invention, the applying unit sends a predetermined number of semiconductor wafers on which photoresist films are formed by changing a set value of the at least one applying condition as first samples to the thickness measuring unit, and sends information on the at least one applying condition to the control unit. The thickness measuring unit measures the thickness distributions of the photoresist films for each of the predetermined number of first samples in a diameter direction of the semiconductor wafer and sends information on the measured predetermined number of thickness distributions to the control unit. The curve plotter, by using the information on at least one applying condition for the predetermined number of first samples and the information on the predetermined number of thickness distributions, plots and stores a thickness distribution graph as a database that comprises a predetermined number of thickness distribution curves indicating the relation between the thickness distribution and the at least one applying condition for the predetermined number of first samples. The predetermined number of thickness distribution curves are different in their thickness uniformity and include a thickness distribution curve having the most favorable thickness uniformity. When the applying apparatus starts its actual operation, the applying unit extracts an arbitrary semiconductor wafer on which the photoresist film is formed and sends the semiconductor wafer as a second sample to the thickness measuring unit, and sends the information on at least one applying condition to the control unit. The thickness measuring unit measures the thickness distribution of the photoresist film for the second sample and sends information on the measured thickness distribution to the control unit. The curve plotter plots a thickness distribution curve of the second sample as a new thickness distribution curve by using the information on at least one applying condition of the second sample and the information on the thickness distribution of the second sample. The correction value calculator compares the new thickness distribution curve with the thickness distribution curve having the most favorable thickness uniformity in the graph, and when the thickness uniformity of the new thickness distribution curve is worse than the most favorable thickness uniformity, the correction value calculator corrects the value of the applying condition for the next time of forming the photoresist film to the value of the applying condition that corresponds to the thickness distribution curve having the most favorable thickness uniformity. The control section generates a control signal on the basis of the correction value of the applying condition.

The above first and second modes may be implemented with one applying apparatus.

A method of controlling a film thickness according to the present invention can be applied to the above applying apparatus. When the above applying apparatus is applied, the method of controlling a film thickness in a first aspect includes the steps of: by the applying unit, sending a predetermined number of semiconductor wafers on which a photoresist film is formed by changing a set value of the at least one applying condition as samples to the thickness measuring unit, and sending information on the at least one applying condition to the control unit; by the thickness measuring unit, measuring the thickness of the photoresist films for each of the predetermined number of samples and sending information on the measured predetermined number of film thicknesses to the control unit; by the control unit, plotting the approximate curve or the regression curve that indicates the relation between the set value of the at least one applying condition and the film thickness on the sample corresponding to each set value by using the information on at least one applying condition and the information on the predetermined number of film thicknesses; by the control unit, calculating a correction value of the at least one applying condition from the thickness target value preset in the applying unit on the basis of the approximate curve or the regression curve; by the control unit, generating the control signal for controlling the at least one applying condition on the basis of the calculated correction value. The applying unit is controlled by the control signal.

A method of controlling a film thickness in a second aspect includes the steps of: by the applying unit, sending a predetermined number of semiconductor wafers on which the photoresist films are formed by changing a set value of the at least one applying condition as first samples to the thickness measuring unit, and sending information on the at least one applying condition to the control unit; by the thickness measuring unit, measuring the thickness distributions of the photoresist films for each of the predetermined number of first samples in a diameter direction of the semiconductor wafer and sending information on the measured predetermined number of thickness distributions to the control unit; and by the control unit, by using the information on at least one applying condition for the predetermined number of first samples and the information on the predetermined number of thickness distributions, plotting and storing a thickness distribution graph as a database that comprises a predetermined number of thickness distribution curves indicating the relation between the thickness distribution and the at least one applying condition for the predetermined number of first samples. The predetermined number of thickness distribution curves are different in their thickness uniformity and include a thickness distribution curve having the most favorable thickness uniformity. The method of controlling a film thickness further includes the steps of: when the applying apparatus starts its actual operation, by the applying unit, extracting an arbitrary semiconductor wafer on which the photoresist film is formed and sending the semiconductor wafer as a second sample to the thickness measuring unit, and sending the information on at least one applying condition to the control unit; by the thickness measuring unit, measuring the thickness distribution of the photoresist film for the second sample and sending information on the measured thickness distribution to the control unit; by the control unit, plotting a thickness distribution curve of the second sample as a new thickness distribution curve by using the information on at least one applying condition of the second sample and the information on the thickness distribution of the second sample; by the control unit, comparing the new thickness distribution curve with the thickness distribution curve having the most favorable thickness uniformity in the graph, and when the thickness uniformity of the new thickness distribution curve is worse than the most favorable thickness uniformity, correcting the value of the applying condition for the next time of forming the photoresist film to the value of the applying condition that corresponds to the thickness distribution curve having the most favorable thickness uniformity; and by the control unit, generating a control signal on the basis of the correction value of the applying condition.

### BRIEF DESCRIPTION OF THE DRAWINGS

FIG. 1 is a diagram for describing a configuration of an applying apparatus according to the present invention;
FIG. 2 is a flowchart for describing the thickness correcting operation of the applying apparatus according to a first embodiment of the present invention;
FIG. 3 is a graph showing the relation between the film thickness of a photoresist produced in the first embodiment of the present invention and the rotation speed of a motor for rotating a semiconductor wafer;
FIG. 4 is a flowchart for describing the thickness correcting operation of the applying apparatus in a second embodiment of the present invention.
FIG. 5 is a graph showing a photoresist thickness distribution of one sample in a diameter direction of the semiconductor wafer, which is measured before the thickness correction in the second embodiment of the present invention;
FIG. 6 is a graph showing the photoresist thickness distributions of a plurality of samples in a diameter direction of the semiconductor wafer, which are measured before the thickness correction in the second embodiment of the present invention; and
FIG. 7 is a graph showing the photoresist thickness distribution of one sample in a diameter direction of the semiconductor wafer, which is measured after the thickness correction in the second embodiment of the present invention.

### DETAILED DESCRIPTION OF THE PREFERRED EMBODIMENT

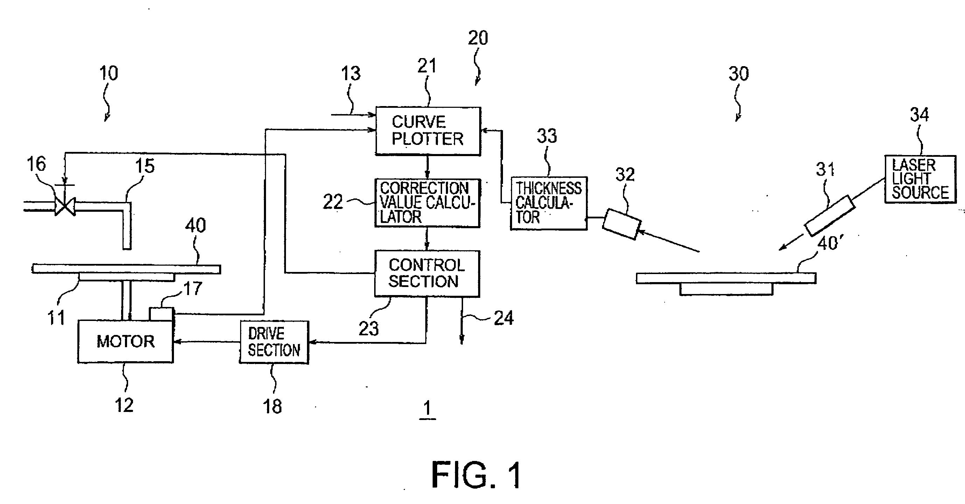

As shown in FIG. 1, an applying apparatus according to the present invention includes an applying unit 10 for applying a photoresist to a semiconductor wafer 40, a control unit 20 for controlling the applying unit 10, and a thickness measuring unit 30 for measuring the film thickness of the photoresist applied to the semiconductor wafer 40'.

The applying unit 10 includes a rotary table 11 for holding the semiconductor wafer 40, a motor 12 for rotating the rotary table 11, and a drop line 15 for dropping the photoresist on the semiconductor wafer 40. The applying unit is normally accommodated in a closed space. The applying unit 10 applies the photoresist to the semiconductor wafer 40 by a spin coat method. The photoresist is dropped from the drop line 15 on the rotating semiconductor wafer 40, and the photoresist expanded uniformly on the semiconductor wafer 40 forms the photoresist film, and then the photoresist film is dried. Besides the motor 12, the applying unit 10 comprises controlled parts for changing values of applying conditions under the control of the control unit 20 and a plurality of sensors for detecting the values of the applying condition.

The applying conditions include such as the rotation speed of the motor 12, rotating time of the motor 12, the kind of chemical liquid (photoresist), the amount of the dropped chemical liquid, dropping time, dropping rate, the temperature of the chemical liquid, the rotation speed of the semiconductor wafer 40 while the chemical liquid is being dropped on it, the ambient humidity, and the setting conditions (for example, a target value of the film thickness) of the apparatus. The values of the applying conditions include input values and detected values. The controlled parts include such as the motor 12, a drop control valve 16 provided in the drop line 15, a cooler, and a heater. The cooler and the heater, which are not shown, regulate the temperature in the space of the applying unit 10. FIG. 1 only illustrates the motor 12 and the drop control valve 16 as examples of the controlled parts. On the other hand, the sensors include such as the rotation speed detector, a voltmeter, an ammeter, a flowmeter, a thermometer, and a hygrometer. The voltmeter and the ammeter detect a voltage and a current in the cooler and the heater, for example. The flowmeter detects the flow of the chemical liquid in the drop line 15. The thermometer and the hygrometer detect the temperature and the humidity in the space of the applying apparatus 10. FIG. 1 only shows the rotation speed detector 17 that detects the rotation speed of the motor 12 as an example of the sensor. The rotation speed detector 17 sends the detected rotation speed as information indicating the applying condition to the control unit 20.

The control unit 20 includes a curve plotter 21, a correction value calculator 22, and a control section 23. The control unit 20 changes the values of the applying conditions by feedback control to control the film thickness of the photoresist. In other words, on the basis of information sent from the applying unit 10 and the thickness measuring unit 30, the control unit 20 controls such as the motor 12 and the drop control valve 16 so that the film thickness of the photoresist corresponds with the target value.

The curve plotter 21 receives information on the applying conditions sent from the applying unit 10 and information on the film thickness sent from the thickness measuring unit 30. On the basis of the information, the curve plotter 21 plots the values of the applying conditions and the corresponding film thickness on a graph. As a result, the values of the applying conditions and an approximate curve or a regression curve of the corresponding film thickness are plotted. FIG. 1 shows that only the detected signal of the rotation speed detector 17 is input to the curve plotter 21 as information on the applying condition from the applying unit 10. However, as described above, there is a plurality of information on the applying conditions input to the curve plotter 21. Simply, FIG. 1 only shows one line 13 as a signal line for inputting the plurality of information.

On the basis of the more suitable one of the plotted approximate curve and regression curve, the correction value calculator 22 calculates a correction value of the applying condition that corresponds to the thickness target value of the photoreisit preset in the applying unit 10.

On the basis of the calculated correction value of the applying condition, the control section 23 generates and outputs signals for controlling the motor 12 and the drop control valve 16. The motor 12 is controlled through a drive section 18. As control signal lines, Fig. 1 shows a control signal line from the control section 23 to the drop control valve 16 and a control signal line from the control section 23 to the drive section 18. However, as described above, there are a plurality of control signal lines that connect the control section 23 to the plurality of controlled parts. Simply, FIG. 1 only shows one line 24 as the controlled signal lines.

The thickness measuring unit 30 measures the film thickness of the photoresist that is applied to the semiconductor wafer 40' by the applying unit 10. The semiconductor wafer 40' is conveyed from the applying unit 10 to a predetermined position in the thickness measuring unit 30 by a conveyer belt. The thickness measuring unit 30 includes a laser light source 34, and an irradiation section 31 which irradiates the semiconductor wafer 40' with a laser light from the laser light source 34. A laser light reception section 32 receives the reflected light from a surface of the photoresist film and a surface of the wafer. A thickness calculator 33 calculates the photoresist film thickness on the semiconductor wafer 40' on the basis of a signal detected in the laser light reception section 32, and outputs information on the calculated film thickness to the curve plotter 21. When the laser light irradiates the semiconductor wafer 40', the thickness calculator 33 calculates the film thickness of the photoresist on its irradiated point. The irradiated point is moved in a diameter direction of the semiconductor wafer 40' to let the laser light irradiate a plurality of points of the semiconductor wafer 40'. The thickness calculator 33 calculates the film thickness on the plurality of points and also calculates their average value as an average film thickness. The thickness calculator 33 also outputs the film thickness on the plurality of points as a thickness distribution in a diameter direction of the semiconductor wafer 40'. The thickness distribution indicates a distribution of the photoresist film thickness in a vertical section of the applied surface of the semiconductor wafer including its central axis.

In the applying apparatus in a first embodiment of this invention, the photoresist is applied by changing the set value of at least one applying condition in the applying unit 10, and thereby a plurality of semiconductor wafers are produced as samples. The applying unit 10 sends information on the applying conditions of the plurality of samples to the control unit 20. In the meantime, the thickness calculator 33 sends information on the measured film thickness (average film thickness) of the plurality of samples to the control unit 20. When the curve plotter 21 receives the information on the applying conditions of the plurality of samples and the information on the film thickness, it plots values of the applying conditions and the corresponding film thickness on the graph. As a result, an approximate curve of the values of the applying conditions and that of the corresponding film thickness are plotted. On the basis of the plotted approximate curves, the correction value calculator 22 calculates a correction value of the applying condition that corresponds to a preset thickness target value of the photoresist. On the basis of the calculated correction value of the applying condition, the control section 23 generates a control signal for controlling the applying condition in the applying unit 10. In this way, the applying apparatus according to the first embodiment is capable of controlling the photoresist applying conditions for a large number of semiconductor wafers by making only a few samples.

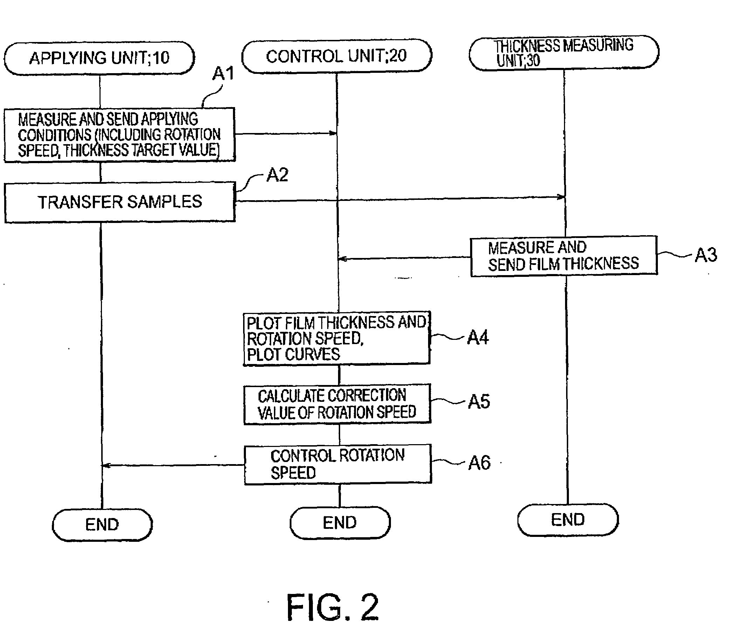

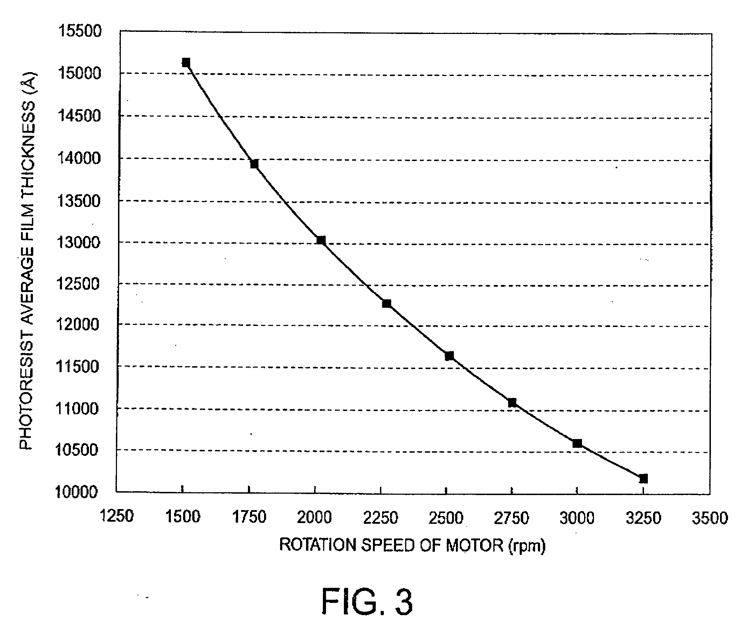

With reference to FIG. 2 and FIG. 3 in addition, a thickness correcting operation of the applying apparatus according to the first embodiment of the present invention will be described. FIG. 2 is a flowchart for describing the thickness correcting operation of the applying apparatus, and FIG. 3 is a graph showing the relation between the film thickness of the photoresist and the rotation speed (rpm) of the motor 12. Here, the rotation speed of the motor 12 will be described as a concrete example of the applying condition. The thickness calculator 33 measures the average film thickness of the semiconductor wafer 40' that has been described earlier and sends the measured film thickness to the curve plotter 21.

Before entering an actual manufacture operation, thickness target value of the photoresist (nm or Å, for example) is set. The applying unit 10 changes the set value of a particular applying condition, which is in this case the rotation speed of the motor 12, and forms the photoresist films on a predetermined number of semiconductor wafers. The predetermined number of semiconductor wafers on which the photoresist films are formed are used as samples. While the applying unit 10 is forming the photoresist films on the predetermined numbers of semiconductor wafers, it detects values of all the applying conditions including the rotation speed of the motor 12, and sends the detected values as information on the applying conditions to the curve plotter 21. The applying unit 10 also sends the preset thickness target value and the input information on the applying condition such as information on the set values and on the chemical liquid to the curve plotter 21 (step A1). The information on the applying conditions is stored in a memory (not shown) of the control unit 20, and used for plotting the approximate curve or the regression curve described later.

Here, the thickness target value is an average film thickness of the photoresist obtained from experience and will be the basis for calculating a correction value of the rotation speed of the motor 12 based on the later-described approximate curve or the regression curve. The applying conditions whose set values can be changed when making the predetermined number of samples may include, besides the rotation speed of the motor 12, the rotating time, the kind of chemical liquid, the amount of drops, the dropping time, the dropping rate, the rotation speed of the wafer while the chemical liquid is being dropped on it, the temperature of the chemical liquid, and the ambient humidity, as mentioned before.

The samples made in the applying unit 10 are sequentially sent to the thickness measuring unit 30 (step A2). In other words, the applying unit makes one sample and sends it to the thickness measuring unit 30, and then turns to making another sample. The thickness measuring unit 30 measures the average film thickness (nm or Å, for example) of the photoresist on the sent samples, and sends the measured average film thickness to the control unit 20 (step A3). These operations are performed for the predetermined number of the samples.

The control unit 20 plots the rotation speed of the motor 12 and the corresponding average film thickness of the samples on the graph, which are included in the information (information stored in the memory) on the applying conditions received from the applying unit 10. The control unit 20 does such plotting for the predetermined number of samples to plot the approximate curve showing the relation between the rotation speed of the motor 12 and the average film thickness that corresponds to each rotation speed (step A4). FIG. 3 shows an example of the approximate curve plotted by the curve plotter 21, which shows the relation between the rotation speed of the motor 12 and the average film thickness of the photoresist. In this case, there are eight samples. The curve plotter 21 may plot the regression curve instead of the approximate curve. Detailed description of the regression curve is omitted since it is well known. In any case, information on the plotted approximate curve or the regression curve is stored in the memory of the control unit 20.

It is desirable that information on many samples should be obtained in order to plot appropriate approximate curves or regression curves. Before entering the actual operation, the applying apparatus 1 measures the film thickness for each of the plurality of samples in the same way as mentioned' above. Obtained information is stored in the memory of the control unit 20. This makes it possible to enhance the accuracy of the approximate curve and the regression curve.

The curve plotter 21 deletes peculiar plotted points that stay out of the approximate curve or the regression curve from the information to be stored. This may be done by previously setting upper and lower ranges in the approximate curve or the regression curve, and by deleting the film thickness that stays out of the ranges as the unusual points. Furthermore, in the case of the regression curve, the most appropriate one (a third regression curve, for example) that makes a correlation coefficient calculated in the curve plotter 21 smaller is selected.

On the basis of the approximate curve or the regression curve obtained in such a way, the correction value calculator 22 calculates a correction value of the applying condition that corresponds to the thickness target value, here, a correction value of the rotation speed of the motor 12 (step A5). On the basis of the calculated correction value of the applying condition (the rotation speed of the motor 12), the control section 23 generates a control signal for controlling the controlled parts (the motor 12) of the applying unit 10. The generated control signal is sent to the controlled part that corresponds to the corrected applying condition. In this case, the control section 23 controls the rotation speed of the motor 12 via the drive section 18 to make it a corrected rotation speed (step A6).

Afterwards, the applying apparatus starts Its actual operation and produces semiconductor wafers for product manufacture on the basis of the correction value of the applying condition.

In the above description, to simplify the explanation, one applying condition is corrected. It is needless to mention that two or more applying conditions may be corrected.

In such a way, it is possible to correct the average thickness of the photoresist film on the semiconductor wafer on the basis of a plurality of applying conditions.

Incidentally, there are some cases where an optimum value of a particular applying condition changes during the actual operation, which causes the film thickness of the photoresist to be less uniform. The thickness correcting operation in a second embodiment of the invention solves such a problem.

With reference to FIG. 1 and FIG. 4 to FIG. 7, the thickness correcting operation of the applying apparatus in the second embodiment of the present invention will be described. The applying apparatus shown in FIG. 1 can also be used for the second embodiment. Here, the description will be given taking the temperature of the chemical liquid as a concrete example of the applying condition. The thickness calculator 33 measures the thickness distribution of the semiconductor wafer 40' described earlier and sends the measured thickness distribution to the curve plotter 21.

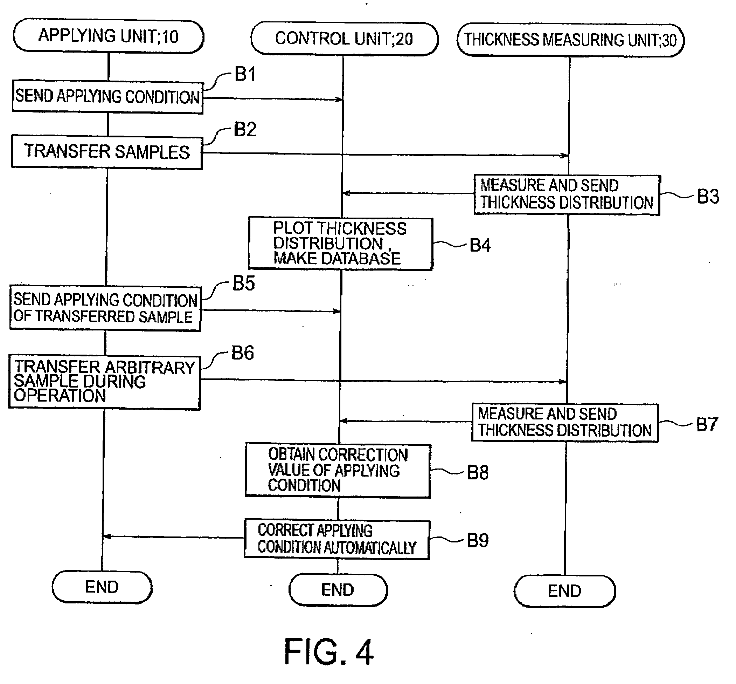

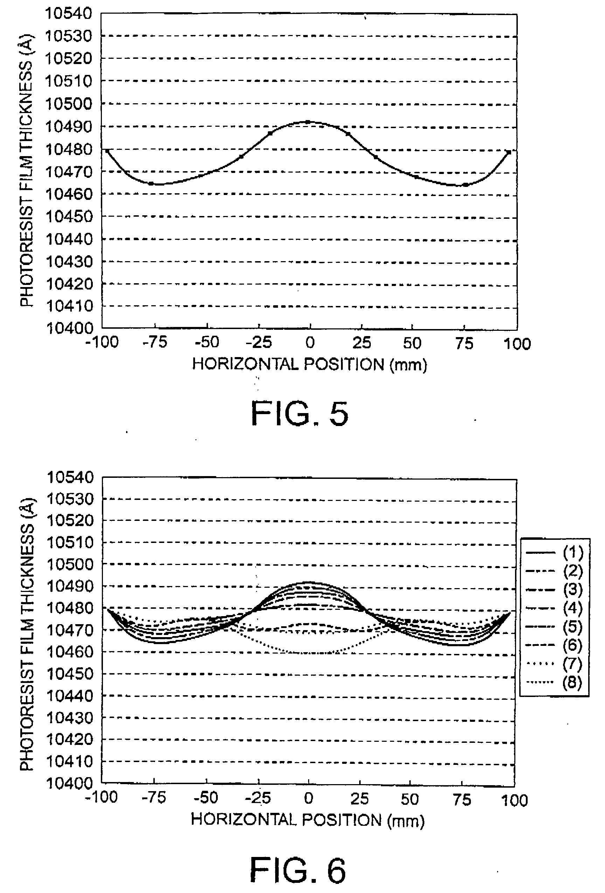

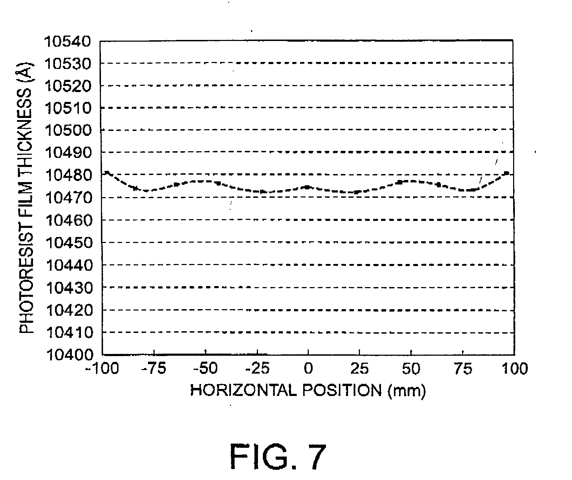

FIG. 4 is a flowchart for describing the thickness correcting operation of the applying apparatus in the second embodiment. FIG. 5 is a graph showing the photoresist thickness distribution of one sample in a diameter direction of the semiconductor wafer, which is measured before the thickness correction in the second embodiment of the present invention. FIG. 6 is a graph showing the photoresist thickness distributions of a plurality of samples before correction. FIG. 7 is a graph showing the photoresist thickness distribution of one sample in a diameter direction of the semiconductor wafer, which is measured after the thickness correction in the second embodiment.

In FIG. 1 and FIG. 4, before entering the actual operation, the applying unit 10 changes the applying condition, which is in this case a set value of the temperature of the chemical liquid, and makes a predetermined number of samples (first samples), and then sends a detected value and the set value of the applying condition that are being made as information on the applying condition to the control unit 20 (step B1). The information on the applying condition is stored in the memory of the control unit 20. In the meantime, the samples that have been made are sequentially sent to the thickness measuring unit 30 (step B2).

The thickness measuring unit 30 measures the thickness distribution of the photoresist on each of sent samples. The thickness calculator 33 sends information on the measured thickness distribution to the control unit 20 (step B3).

The control unit 20 stores the information on the thickness distribution in the memory. On the basis of the received information on the thickness distribution, the curve plotter 21 plots a graph indicating the thickness distribution curve as shown in FIG. 5.

In FIG. 5, there are eleven measure points in the thickness distribution. "O" on the horizontal axis indicates the position of the central axis of the semiconductor wafer, that is, the position of the rotation axis of the rotary table 11. Each number on the horizontal axis indicates the distance (mm) up to the central axis. A right part from the central axis towards the section is positive and a left part is negative. Furthermore, the vertical axis in FIG. 5 indicates the film thickness (Å) of the photoresist. The same applies to FIG. 6 and FIG. 7.

On the basis of the received information (information stored in the memory) on the thickness distributions of the predetermined number of samples (here, eight), the control unit 20 plots a thickness distribution graph as shown in FIG. 6. The thickness distribution graph comprising the thickness distribution curves for the predetermined number of samples is stored in the memory. During the actual operation of the applying apparatus 1 later, the thickness distribution graph is used as a database for correction to obtain the applying condition having the best thickness distribution uniformity (step B4). The thickness distribution curves (1) to (8) in the thickness distribution graph shown in FIG. 6 are different in their thickness uniformity because of the different set values of the applying conditions, here, the different temperatures of a particular chemical liquid. The thickness distribution curve (6) included therein has the most favorable thickness uniformity.

Such a thickness distribution graph is plotted for each of the plurality of applying conditions and stored in the memory. In the database, the thickness distributions of each sample and the set values of their applying conditions are relevantly stored.

When the applying apparatus starts its actual operation, that is, starts forming the photoresist films for product manufacture, the applying unit 10 sends information on all the applying conditions at the time of the start of the actual operation to the control unit 20 (step B5). The information on the applying conditions is stored in the memory. Among a plurality of semiconductor wafers on which the photoresist films are formed, one semiconductor wafer is extracted as a sample (a second sample) regularly or at random, and sent to the thickness measuring unit 30 (step B6).

The thickness calculator 33 measures the photoresist thickness distribution of the sent sample and sends information on the measured thickness distribution to the control unit 20 (step B7).

On the basis of the sent information on the thickness distribution, the curve plotter 21 plots new thickness distribution curve and stores this in the memory. By using the plotted new thickness distribution curve and the information (information stored in the memory) on the applying conditions sent from the applying unit 10, the correction value calculator 22 calculates a correction value of the applying conditions with reference to the database (step B8). As described before, the applying conditions include such as the temperature of the chemical liquid, the amount of dropped chemical liquid, dropping time, dropping rate, and the rotation speed of the semiconductor wafer when the chemical liquid is dropped on it.

For example, there is a sample ((1) of FIG. 6) which has an nonuniform film thickness because of the temperature of the chemical liquid, among the plurality of the applying conditions. In this case, the correction value calculator 22 takes out the thickness distribution graph of the temperature of the chemical liquid from the database and compares a new thickness distribution curve with the thickness distribution curve (6) which has the most favorable thickness uniformity. As a result of the comparison, if the thickness uniformity of the new thickness distribution curve is worse than the most favorable thickness uniformity, the correction value calculator 22 outputs the temperature of the chemical liquid of the sample which has the favorable thickness uniformity ((6) of FIG. 6) as a corrected applying condition, that is, a correction value.

Finally, on the basis of the corrected applying condition, the control section 23 generates a control signal for controlling the controlled parts of the applying unit 10, and controls the controlled parts on the basis of the generated control signal, and makes a corrected applying condition (step B9). When only the temperature of the chemical liquid is corrected among the plurality of applying conditions, only the temperature of the chemical liquid is controlled. It is appreciated that when the plurality of applying conditions are corrected, each of the plurality of corrected applying conditions is controlled.

It is thereby possible to correct the nonuniformity of the photoresist thickness distribution on the semiconductor wafer.

Since the thickness calculator 33 has a function of measuring the average film thickness and a function of measuring the thickness distribution, the applying apparatus according to the present invention is capable of having both the correcting function of the above first embodiment and the correcting function of the second embodiment. The correcting function of the first embodiment and the correcting function of the second embodiment may be executed separately or may be executed in parallel.

As another embodiment, the following example may be applied. It is preferable to previously set a range of the rotation speed of the motor 12 for each applying condition. Therefore, it is preferable that the control unit 20 has an alarm function for a shift of the approximate curve. In other words, the control section 23 activates the alarm at the corrected rotation speed that exceeds the maximum rotation speed of the motor 12. When the alarm is activated, the control section 23 prohibits the applying operation to safely use the applying apparatus.

It is preferable that a flag is set or groups of the applying conditions are formed to distinguish between the applying condition to be corrected and the applying condition not to be corrected. This facilitates the determination whether a correction is necessary or not.

According to the present invention, by connecting the applying unit and the control unit and the thickness measuring unit on line and having the control unit control the applying unit, it is possible to control the applying condition of the photoresist for many semiconductor wafers with only a few samples. This enables the applying apparatus to operate efficiently.

Furthermore, the film thickness of the predetermined number of samples having different applying conditions (the kind of chemical liquid, for example) is measured. This provides stability in accurately measuring the film thickness of the photoresist in the applying apparatus.

## Claims

1. An applying apparatus (1) including an applying unit (10) for applying a photoresist to a semiconductor wafer (40) by a spin coat method on the basis of at least one applying condition, a thickness measuring unit (30) for measuring the film thickness of the photoresist applied to the semiconductor wafer (40') by said applying unit, and a control unit (20) for controlling said applying unit, which is **characterized in that**:
on the basis of information on said at least one applying condition for a predetermined number of samples sent from said applying unit and information on the film thickness on said predetermined number of samples sent from said thickness measuring unit, said control unit plots an approximate curve or a regression curve that indicates the relation between the film thickness and said at least one applying condition of said predetermined number of samples; and
when said applying apparatus starts its actual operation, said control unit calculates a correction value of said at least one applying condition from a thickness target value preset in said applying unit on the basis of said approximate curve or said regression curve that are plotted in relation to said predetermined number of samples, and said control unit generates a control signal for controlling said at least one applying condition on the basis of the calculated correction value to control said applying unit by said control signal.

2. The applying apparatus according to claim 1, wherein
said applying unit sends a predetermined number of semiconductor wafers on which photoresist films are formed by changing a set value of said at least one applying condition as said predetermined number of samples to said thickness measuring unit, and sends information on said at least one applying condition to said control unit;
said thickness measuring unit measures the thickness of the photoresist films for each of said predetermined number of samples and sends information on said measured predetermined number of film thicknesses to said control unit; and
said control unit includes a curve plotter (21), a correction value calculator (22), and a control section (23);
said curve plotter plots said approximate curve or said regression curve that indicates the relation between said set value of said at least one applying condition and the film thickness on the sample corresponding to each set value by using the information on said at least one applying condition and the information on said predetermined number of film thicknesses;
said correction value calculator calculates a correction value of said at least one applying condition from said thickness target value on the basis of said approximate curve or said regression curve; and
said control section generates said control signal for controlling said at least one applying condition on the basis of the calculated correction value, and controls said applying unit by said control signal.

3. The applying apparatus according to claim 2, wherein
said applying unit comprises a motor (12) for rotating said semiconductor wafer, and said at least one applying condition is the rotation speed of said motor, and the control signal for controlling said at least one applying condition is a signal for controlling the rotation speed of said motor.

4. The applying apparatus according to claim 2, wherein
when the sample has a film thickness that exceeds a range previously set in said approximate curve or said regression curve, said curve plotter deletes the film thickness of said sample as a peculiar point.

5. An applying apparatus (1) including an applying unit (10) for applying a photoresist to a semiconductor (40) wafer by a spin coat method on the basis of at least one applying condition, a thickness measuring unit (30) for measuring a thickness distribution of the photoresist applied to the semiconductor wafer (40') by said applying unit in a diameter direction of the semiconductor wafer, and a control unit (20) for controlling said applying unit, which is **characterized in that**:
said applying unit sends a predetermined number of semiconductor wafers on which photoresist films are formed by changing a set value of said at least one applying condition as first samples to said thickness measuring unit, and sends information on said at least one applying condition to said control unit;
said thickness measuring unit measures the thickness distributions of the photoresist films for each of said predetermined number of first samples and sends information on said measured predetermined number of thickness distributions to said control unit; and
said control unit includes a curve plotter (21), a correction value calculator (22), and a control section (23);
said curve plotter, by using the information on said at least one applying condition for said predetermined number of first samples and the information on said predetermined number of thickness distributions, plots and stores a thickness distribution graph as a database that comprises a predetermined number of thickness distribution curves indicating the relation between the thickness distribution and said at least one applying condition for said predetermined number of first samples, said predetermined number of thickness distribution curves being different in their thickness uniformity and include a thickness distribution curve having the most favorable thickness uniformity;
when the applying apparatus starts its actual operation, said applying unit extracts an arbitrary semiconductor wafer on which the photoresist film is formed and sends said semiconductor wafer as a second sample to said thickness measuring unit, and sends the information on said at least one applying condition to said control unit;
said thickness measuring unit measures the thickness distribution of the photoresist film for said second sample and sends information on said measured thickness distribution to said control unit;
said curve plotter plots a thickness distribution curve of said second sample as a new thickness distribution curve by using the information on said at least one applying condition of said second sample and the information on said thickness distribution of said second sample;
said correction value calculator compares said new thickness distribution curve with said thickness distribution curve having the most favorable thickness uniformity in said graph, and when the thickness uniformity of said new thickness distribution curve is worse than said most favorable thickness uniformity, said correction value calculator corrects the value of the applying condition for the next time of forming the photoresist film to the value of the applying condition that corresponds to said thickness distribution curve having the most favorable thickness uniformity; and
said control section generates a control signal on the basis of the correction value of the applying condition, and controls said applying unit by said control signal.

6. The applying apparatus according to claim 5, wherein
said applying unit comprises a motor (12) for rotating said semiconductor wafer, and said applying condition is the rotation speed of said motor, and said control signal is a signal for controlling the rotation speed of said motor.

7. The applying apparatus according to claim 2, wherein
said thickness measuring unit has a function of measuring the film thickness of said photoresist and a function of measuring the thickness distribution of said photoresist in a diameter direction of the semiconductor wafer;
said applying unit sends a predetermined number of semiconductor wafers on which the photoresist films are formed by changing a set value of said at least one applying condition as first samples to said thickness measuring unit, and sends information on said at least one applying condition to said control unit;
said thickness measuring unit measures the thickness distributions of the photoresist films for each of said predetermined number of first samples and sends information on said measured predetermined number of thickness distributions to said control unit;
said curve plotter, by using the information on said at least one applying condition for said predetermined number of first samples and the information on said predetermined number of thickness distributions, plots and stores a thickness distribution graph as a database that comprises a predetermined number of thickness distribution curves indicating the relation between the thickness distribution and said at least one applying condition for said predetermined number of first samples, said predetermined number of thickness distribution curves being different in their thickness uniformity and include a thickness distribution curve having the most favorable thickness uniformity;
when the applying apparatus starts its actual operation, said applying unit extracts an arbitrary semiconductor wafer on which the photoresist film is formed and sends said semiconductor wafer as a second sample to said thickness measuring unit, and sends the information on said at least one applying condition to said control unit;
said thickness measuring unit measures the thickness distribution of the photoresist film for said second sample and sends information on said measured thickness distribution to said control unit;
said curve plotter plots a thickness distribution curve of said second sample as a new thickness distribution curve by using the information on said at least one applying condition of said second sample and the information on said thickness distribution of said second sample;
said correction value calculator compares said new thickness distribution curve with said thickness distribution curve having the most favorable thickness uniformity in said graph, and when the thickness uniformity of said new thickness distribution curve is worse than said most favorable thickness uniformity, said correction value calculator corrects the value of the applying condition for the next time of forming the photoresist film to the value of the applying condition that corresponds to said thickness distribution curve having the most favorable thickness uniformity; and
said control section generates a control signal on the basis of the correction value of the applying condition, and controls said applying unit by said control signal.

8. The applying apparatus according to claim 7, wherein
said applying unit comprises a motor (12) for rotating said semiconductor wafer, and said at least one applying condition is the rotation speed of said motor, and the control signal for controlling said at least one applying condition is a signal for controlling the rotation speed of said motor.

9. The applying apparatus according to claim 7, wherein
when the sample has a film thickness that exceeds a range previously set in said approximate curve or said regression curve, said curve plotter deletes the film thickness of said sample as a peculiar point.

10. A method of controlling a film thickness for an applying apparatus (1) including an applying unit (10) for applying a photoresist to a semiconductor wafer (40) by a spin coat method on the basis of at least one applying condition, a thickness measuring unit (30) for measuring the film thickness of the photoresist applied to the semiconductor wafer (40') by said applying unit, and a control unit (20) for controlling said applying unit, said method comprising the steps of:
by said applying unit, sending (A2) a predetermined number of semiconductor wafers on which the photoresist film is formed by changing a set value of said at least one applying condition as samples to said thickness measuring unit, and sending (A1) information on said at least one applying condition to said control unit;
by said thickness measuring unit, measuring (A3) the thickness of the photoresist films for each of said predetermined number of samples and sending (A3) information on said measured predetermined number of film thicknesses to said control unit;
by said control unit, plotting (A4) said approximate curve or said regression curve that indicates the relation between said set value of said at least one applying condition and the film thickness on the sample corresponding to each set value by using the information on said at least one applying condition and the information on said predetermined number of film thicknesses;
by said control unit, calculating (A5) a correction value of said at least one applying condition from a thickness target value preset in said applying unit on the basis of said approximate curve or said regression curve;
by said control unit, generating said control signal for controlling said at least one applying condition on the basis of the calculated correction value; and
controlling (A6) said applying unit by said control signal.

11. The method of controlling a film thickness according to claim 10, wherein
said applying unit comprises a motor (12) for rotating said semiconductor wafer, and said at least one applying condition is the rotation speed of said motor, and the control signal for controlling said at least one applying condition is a signal for controlling the rotation speed of said motor.

12. The method of controlling a film thickness according to claim 10 further comprising the step of:
when the sample has a film thickness that exceeds a range previously set in said approximate curve or said regression curve, deleting the film thickness of said sample as a peculiar point by said control unit.

13. A method of controlling a film thickness for an applying apparatus (1) including an applying unit (10) for applying a photoresist to a semiconductor wafer (40) by a spin coat method on the basis of at least one applying condition, a thickness measuring unit (30) for measuring a thickness distribution of the photoresist applied to the semiconductor wafer (40') by said applying unit in a diameter direction of the semiconductor wafer, and a control unit (20) for controlling said applying unit, which is charaterized in that said method comprising the steps of:
by said applying unit, sending (B2) a predetermined number of semiconductor wafers on which the photoresist films are formed by changing a set value of said at least one applying condition as first samples to said thickness measuring unit, and sending (B1) information on said at least one applying condition to said control unit;
by said thickness measuring unit, measuring (B3) the thickness distributions of the photoresist films for each of said predetermined number of first samples and sending (B3) information on said measured predetermined number of thickness distributions to said control unit; and
by said control unit, by using the information on said at least one applying condition for said predetermined number of first samples and the information on said predetermined number of thickness distributions, plotting and storing (B4) a thickness distribution graph as a database that comprises a predetermined number of thickness distribution curves indicating the relation between the thickness distribution and said at least one applying condition for said predetermined number of first samples, said predetermined number of thickness distribution curves being different in their thickness uniformity and include a thickness distribution curve having the most favorable thickness uniformity;
when the applying apparatus starts its actual operation, by said applying unit, extracting (B6) an arbitrary semiconductor wafer on which the photoresist film is formed and sending (B6) said semiconductor wafer as a second sample to said thickness measuring unit, and (B5) sending the information on said at least one applying condition to said control unit;
by said thickness measuring unit, measuring (B7) the thickness distribution of the photoresist film for said second sample and sending information on said measured thickness distribution to said control unit;
by said control unit, plotting a thickness distribution curve of said second sample as a new thickness distribution curve by using the information on said at least one applying condition of said second sample and the information on said thickness distribution of said second sample;
by said control unit, comparing said new thickness distribution curve with said thickness distribution curve having the most favorable thickness uniformity in said graph, and when the thickness uniformity of said new thickness distribution curve is worse than said most favorable thickness uniformity, and correcting (B8) the value of the applying condition for the next time of forming the photoresist film to the value of the applying condition that corresponds to said thickness distribution curve having the most favorable thickness uniformity;
by said control unit, generating a control signal on the basis of the correction value of the applying condition; and
controlling (B9) said applying unit by said control signal.

14. The method of controlling a film thickness according to claim 13, wherein
said applying unit comprises a motor (12) for rotating said semiconductor wafer, and said applying condition is the rotation speed of said motor, and said control signal is a signal for controlling the rotation speed of said motor.
